(19) Europäisches Patentamt

European Patent Office

Office européen des brevets

(11) **EP 4 492 422 B1**

(12) **FASCICULE DE BREVET EUROPEEN**

(45) Date de publication et mention de la délivrance du brevet:
**12.11.2025  Bulletin 2025/46**

(21) Numéro de dépôt: **24186903.1**

(22) Date de dépôt: **05.07.2024**

(51) Classification Internationale des Brevets (IPC):
***H01H 47/00*** *(2006.01)*

(52) Classification Coopérative des Brevets (CPC):
**H01H 47/002;** H01H 3/3031; H01H 3/3052;
H01H 71/2463; H01H 2071/044

(54) **PROCÉDÉ DE DÉTECTION D'UNE DÉGRADATION D'UN APPAREIL DE COMMUTATION COMPRENANT UN ACTIONNEUR ÉLECTROMAGNÉTIQUE**

VERFAHREN ZUR ERKENNUNG EINER VERSCHLECHTERUNG EINER SCHALTVORRICHTUNG MIT EINEM ELEKTROMAGNETISCHEN AKTUATOR

METHOD FOR DETECTING A DEGRADATION OF A SWITCHING DEVICE HAVING AN ELECTROMAGNETIC ACTUATOR

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **13.07.2023  FR 2307588**

(43) Date de publication de la demande:
**15.01.2025  Bulletin 2025/03**

(73) Titulaire: **SCHNEIDER ELECTRIC INDUSTRIES SAS**
**92500 Rueil-Malmaison (FR)**

(72) Inventeurs:
• **MELEY, Jean-Pierre**
**38330 ST ISMIER (FR)**
• **EL KHOURY, Diana**
**38000 GRENOBLE (FR)**
• **ALBERTO, Diego**
**38700 CORENC (FR)**

(74) Mandataire: **Plasseraud IP**
**104 Rue de Richelieu**
**CS92104**
**75080 Paris Cedex 02 (FR)**

(56) Documents cités:
US-A1- 2017 287 666    US-A1- 2023 025 832
US-B2- 7 692 522

EP 4 492 422 B1

## Description

### Domaine technique

La présente invention se rapporte au domaine des appareils de commutation pour équipements électriques, par exemple pour des équipements électriques de basse et moyenne tension. L'appareil de commutation peut par exemple être un disjoncteur.

### Technique antérieure

Un appareil de commutation basse ou moyenne tension peut comprendre un ou plusieurs actionneurs électromagnétiques permettant de déverrouiller un mécanisme de commande à ressort, permettant de déplacer un contact électrique mobile, de façon à ouvrir ou fermer un circuit électrique. Dans le cas d'un disjoncteur, l'ouverture du circuit électrique est réalisée en cas d'apparition d'un défaut dans le circuit électrique. Le défaut peut être notamment un court-circuit entre deux phases, ou entre une phase et la terre. La fermeture du circuit permet la mise sous-tension d'une charge.

L'actionneur électromagnétique comprend un noyau magnétique mobile et une bobine de commande. Sous l'action d'un courant électrique parcourant la bobine de commande, le noyau magnétique se déplace. Le noyau magnétique est mécaniquement couplé au mécanisme de commande agissant sur les contacts électriques mobiles de façon à pouvoir ouvrir ou fermer le circuit électrique.

Afin d'assurer la sécurité du réseau électrique et des personnes, il est important de pouvoir vérifier le bon fonctionnement des appareils de commutation tout au long de leur durée de vie. Pour cela, les disjoncteurs peuvent comprendre des circuits de mesure permettant de diagnostiquer en temps réel l'état de l'actionneur électromagnétique. Cet actionneur électromagnétique est généralement soumis aux effets d'un vieillissement qui peut dégrader progressivement ses fonctions électriques ou mécaniques, et à terme le rendre inopérant. Il est donc important pour les utilisateurs de pouvoir suivre l'évolution de l'état de l'actionneur électromagnétique. Il est souhaitable de permettre aux utilisateurs d'intervenir pour réparer ou changer l'actionneur électromagnétique à un moment opportun dans la gestion du réseau électrique.

Le document US7692522 décrit un procédé selon le préambule de la revendication 1.

### Résumé

A cette fin, l'invention propose un procédé de détection d'une dégradation d'un appareil de commutation comprenant un actionneur électromagnétique configuré pour déverrouiller un mécanisme de commande comprenant un organe élastique configuré pour déplacer un contact électrique mobile de façon à ouvrir ou fermer un circuit électrique, le procédé comprenant les étapes :

(i) commander l'actionneur électromagnétique,
(ii) mesurer un courant circulant dans l'actionneur électromagnétique lors de la commande de l'actionneur électromagnétique,
(iii) déterminer à partir du courant mesuré un temps de réaction de l'actionneur électromagnétique,
(iv) déterminer à partir du courant mesuré une grandeur représentative du courant circulant dans l'actionneur électromagnétique lors de la commande de l'actionneur électromagnétique,
(v) déterminer un paramètre sous la forme d'un polynôme du temps de réaction déterminé et de la grandeur déterminée représentative du courant circulant dans l'actionneur électromagnétique lors de la commande de l'actionneur électromagnétique,
(vi) itérer les étapes (i) à (v) pour un ensemble de commande successives de l'actionneur électromagnétique de façon à obtenir un ensemble de valeurs du paramètre déterminé,
(vii) déterminer une dégradation de l'actionneur électromagnétique à partir de l'évolution des valeurs de l'ensemble au cours des commandes successives de l'actionneur électromagnétique.

Le procédé de détection d'une dégradation de l'appareil de commutation est un procédé permettant de détecter une évolution du comportement de l'appareil de commutation en raison du vieillissement de ses composants.
Le vieillissement des composants comprend par exemple l'usure, les déformations, l'effet de la corrosion, l'évolution des performances magnétiques, l'évolution des propriétés tribologiques des composants.
Dans le cas où l'actionneur électromagnétique fonctionne de façon nominale, les valeurs de l'ensemble n'évoluent sensiblement pas au cours des actionnements successifs. Autrement dit, les différentes valeurs de l'ensemble sont sensiblement constantes. A l'inverse, une dégradation progressive de l'actionneur électromagnétique a tendance à provoquer une évolution des valeurs au cours des actionnements successifs, en particulier une fluctuation de ces valeurs.

Les valeurs de l'ensemble ne sont plus sensiblement constantes et présentent une fluctuation significative. Cette évolution progressive permet de détecter une dégradation de l'actionneur magnétique de l'appareil de commutation. Le procédé de détection d'une dégradation de l'appareil de commutation est un procédé permettant également de d'anticiper l'apparition d'un défaut de l'appareil de commutation.

En effet, une dégradation non corrigée de l'appareil de commutation peut conduire à terme à l'apparition d'un défaut.

Les caractéristiques listées dans les paragraphes suivant peuvent être mises en œuvre indépendamment les unes des autres ou selon toutes les combinaisons techniquement possibles :

A l'étape (vii), l'évolution des valeurs de l'ensemble peut être une fluctuation des valeurs de l'ensemble au cours des commandes successives de l'actionneur électromagnétique.

L'ensemble de valeurs du polynôme du temps de réaction déterminé et de la grandeur déterminée est obtenu par une succession de commandes consécutives de l'actionneur électromagnétique de l'appareil de commutation.

Chaque valeur de l'ensemble de valeurs du polynôme du temps de réaction déterminé et de la grandeur déterminée correspond à un actionnement distinct de l'actionneur électromagnétique de l'appareil de commutation.

L'appareil de commutation peut être un disjoncteur.

En variante, l'appareil de commutation peut être un interrupteur.

Selon une autre variante, l'appareil de commutation peut être un sectionneur.

L'appareil de commutation comprend :

- un contact électrique mobile entre une position d'ouverture d'un circuit électrique et une position de fermeture du circuit électrique,
- un mécanisme de commande comprenant :

-- un organe élastique configuré pour déplacer le contact électrique de la position de fermeture à la position d'ouverture ou de la position d'ouverture à la position de fermeture, de façon à respectivement ouvrir ou fermer le circuit électrique,
-- un organe de déverrouillage configuré pour passer d'une position de verrouillage dans laquelle l'organe élastique est maintenu dans un état de tension à une position de libération dans laquelle l'organe élastique est libre de se détendre de façon à déplacer le contact électrique de la position de fermeture à la position d'ouverture ou de la position d'ouverture à la position de fermeture,

- un actionneur électromagnétique configuré pour déplacer l'organe de déverrouillage de la position de verrouillage à la position de libération.

Selon un mode de réalisation, dit premier mode de réalisation :

- l'organe élastique est configuré pour déplacer le contact électrique de la position de fermeture à la position d'ouverture de façon à ouvrir le circuit électrique, et
- l'organe de déverrouillage est configuré pour passer d'une position de verrouillage dans laquelle l'organe élastique est maintenu dans un état de tension à une position de libération dans laquelle l'organe élastique est libre de se détendre de façon à déplacer le contact électrique de la position de fermeture à la position d'ouverture.

Selon un autre mode de réalisation, dit deuxième mode de réalisation:

- l'organe élastique est configuré pour déplacer le contact électrique de la position d'ouverture la position de fermeture, de façon à fermer le circuit électrique,
- l'organe de déverrouillage est configuré pour passer d'une position de verrouillage dans laquelle l'organe élastique est maintenu dans un état de tension à une position de libération dans laquelle l'organe élastique est libre de se détendre de façon à déplacer le contact électrique de la position d'ouverture à la position de fermeture.

L'organe élastique est configuré pour appliquer une force d'entrainement sur le contact électrique mobile. L'organe élastique est lié à un élément d'entrainement configuré pour déplacer le contact électrique mobile de façon à ouvrir ou fermer un circuit électrique. L'élément d'entrainement comprend par exemple une biellette de liaison.

Selon le premier mode de réalisation, l'organe de déverrouillage peut passer d'une position de verrouillage dans laquelle l'organe élastique du mécanisme de commande est élastiquement contraint et dans laquelle le contact électrique mobile est en position de fermeture du circuit électrique, à une position déverrouillée dans laquelle l'organe élastique du mécanisme de commande est libéré et déplace le contact électrique mobile de la position de fermeture du circuit électrique à une position d'ouverture du circuit électrique.

Selon le deuxième mode de réalisation, l'organe de déverrouillage peut passer d'une position de verrouillage dans laquelle l'organe élastique du mécanisme de commande est élastiquement contraint et dans laquelle le contact électrique mobile est en position d'ouverture du circuit électrique, à
une position déverrouillée dans laquelle l'organe élastique du mécanisme de commande est libéré et déplace le contact électrique mobile d'une position d'ouverture du circuit électrique à la position de fermeture du circuit électrique.

On entend par déverrouiller le mécanisme de commande le fait de libérer l'organe élastique du mécanisme de commande. En d'autres termes, déverrouiller le mécanisme de commande équivaut à déplacer l'organe de déverrouillage de la position de verrouillage à la position de libération.

L'actionneur électromagnétique est un électroaimant.

L'actionneur électromagnétique comprend une bobine de commande et un noyau magnétique configuré pour se déplacer sous l'action d'un champ magnétique créé par une circulation de courant électrique dans la bobine de commande.

Le noyau magnétique est par exemple mobile en translation.

**Le** noyau magnétique est mécaniquement couplé à un organe de déverrouillage configuré pour passer d'une position de verrouillage dans laquelle l'organe élastique est maintenu dans un état de tension à une position de libération dans laquelle l'organe élastique est libre de se détendre de façon à déplacer le contact électrique de la position de fermeture à la position d'ouverture.

On entend par mesurer un courant circulant dans l'actionneur électromagnétique le fait de mesurer l'intensité du courant électrique circulant dans l'actionneur électromagnétique.

Le courant circulant dans l'actionneur électromagnétique est détecté par un circuit électronique de mesure.

Le courant circulant dans l'actionneur électromagnétique est échantillonné, par exemple avec une fréquence d'échantillonnage comprise entre 1 kHz et 100 kHz.

L'actionneur électromagnétique comprend un élément de couplage couplant mécaniquement le noyau magnétique à l'organe de déverrouillage.

Le mécanisme de commande peut comprendre des éléments mobiles en rotation.

Le mécanisme de commande peut comprendre des éléments mobiles en translation.

L'organe élastique peut être un ressort, par exemple un ressort spiral ou un ressort hélicoïdal.

L'actionneur électromagnétique est configuré pour déclencher un déplacement du contact électrique mobile afin d'ouvrir le circuit électrique.
Lorsque l'appareil de commutation est un disjoncteur, l'actionneur électromagnétique est configuré pour déclencher une ouverture du circuit électrique en cas de présence d'un défaut sur le circuit électrique.

Selon un aspect du procédé de détection proposé, le temps de réaction de l'actionneur électromagnétique est déterminé à partir des variations temporelles du courant mesuré.

Le procédé proposé ne demande ainsi l'installation d'aucun capteur supplémentaire, tel un capteur de déplacement du contact électrique ou un capteur du déplacement d'un élément du mécanisme de commande.

Le procédé proposé comprend une sous-étape de détermination des variations temporelles du courant mesuré.

Selon un exemple de mise en œuvre du procédé de détection, le temps de réaction de l'actionneur électromagnétique est égal à une durée écoulée entre un instant de début de circulation du courant électrique dans l'actionneur électromagnétique et un instant correspondant à une valeur minimale locale du courant électrique circulant dans l'actionneur électromagnétique.

Selon un mode de réalisation du procédé de détection, la grandeur représentative du courant circulant dans l'actionneur électromagnétique lors de l'actionnement de l'appareil de commutation est une valeur maximale locale du courant électrique circulant dans l'actionneur électromagnétique.

A l'étape (v), le paramètre est déterminé par un polynôme à deux indéterminées, c'est-à-dire une somme de monômes à deux indéterminées. Une première indéterminée est le temps de réaction déterminé, et la deuxième indéterminée est la grandeur déterminée représentative du courant circulant dans l'actionneur électromagnétique lors de la commande de l'actionneur électromagnétique.
Chaque monôme du polynôme est ainsi déterminé par le produit : du temps de réaction déterminé, élevé à une première puissance donnée, de la grandeur déterminée représentative du courant circulant dans l'actionneur électromagnétique lors de la commande de l'actionneur électromagnétique, élevée à une deuxième puissance donnée, et d'un coefficient constant.
Chaque monôme peut s'écrire sous la forme :

[Math. 2]

$$A_i * (ta)^{k_i} * (i1)^{L_i}$$

Le polynôme formant le paramètre P peut ainsi s'écrire :

[Math. 3]

$$P = \sum_{i=0}^{H} A_i * (ta)^{k_i} * (i1)^{L_i}$$

avec les coefficients $k_0$, ..., $k_H$ prenant des valeurs rationnelles, les coefficients $L_0$, ..., $L_H$ prenant des valeurs rationnelles, et les coefficients $A_i$ prenant des valeurs rationnelles.

Parmi une multitude de paramètres étudiés, le déposant a conclu que le polynôme formé à partir du temps de réaction de l'actionneur électromagnétique et de la valeur maximale locale du courant circuit dans l'actionneur électromagnétique rend le mieux compte d'une dégradation progressive de cet actionneur électromagnétique. Le polynôme est ainsi un polynôme à deux indéterminées.

Selon un mode de réalisation particulier du procédé de détection proposé, le paramètre P est égal au produit du temps de réaction déterminé et de la grandeur déterminée représentative du courant circulant dans l'actionneur électromagnétique lors de la commande de l'actionneur électromagnétique.

Autrement dit, dans ce cas particulier de mise en œuvre du procédé, le polynôme comprend un terme unique, autrement dit est un monôme. La première puissance du monôme est égale à 1 et la deuxième puissance du monôme est également égale à 1.

Le monôme formé est alors égal au produit du temps de réaction déterminé et de la grandeur déterminée représentative du courant circulant dans l'actionneur électromagnétique lors de la commande de l'actionneur électromagnétique, c'est-à-dire au résultat de la multiplication de la valeur du temps de réaction déterminé par la valeur de la grandeur déterminée représentative du courant circulant dans l'actionneur électromagnétique lors de la commande de l'actionneur électromagnétique.

La valeur maximale locale du courant est obtenue pour un instant compris entre un instant de début de circulation du courant électrique dans l'actionneur électromagnétique et un instant correspondant à un minimum local du courant électrique circulant dans l'actionneur électromagnétique.

Selon un mode de réalisation, le procédé de détection comprend les sous-étapes :

- calculer une valeur d'un paramètre statistique représentatif d'une fluctuation des valeurs de l'ensemble de valeurs du polynôme du temps de réaction déterminé et de la grandeur déterminée,
- déterminer une dégradation de l'actionneur électromagnétique à partir de la valeur calculée du paramètre statistique.

Selon un exemple de mise en œuvre du procédé de détection, le paramètre statistique représentatif d'une fluctuation des valeurs de l'ensemble de valeurs du polynôme du temps de réaction déterminé et de la grandeur déterminée comprend une différence entre :

- une valeur courante du polynôme du temps de réaction déterminé et de la grandeur déterminée, déterminée pour un actionnement courant de l'appareil de commutation, et
- une valeur moyenne des valeurs du polynôme du temps de réaction déterminé et de la grandeur déterminée obtenues pour un nombre prédéterminé d'actionnements précédant l'actionnement courant de l'appareil de commutation.

La valeur moyenne peut être une moyenne glissante calculée à partir des valeurs correspondant aux actionnements précédent l'actionnement courant, et comprenant un nombre de valeurs égal au nombre prédéterminé d'actionnements.

Selon un exemple de mise en œuvre du procédé de détection, le paramètre statistique représentatif d'une fluctuation des valeurs de l'ensemble de valeurs du polynôme du temps de réaction déterminé et de la grandeur déterminée comprend un écart-type des valeurs du polynôme du temps de réaction déterminé et de la grandeur déterminée déterminé pour un ensemble d'actionnements de l'appareil de commutation réalisés dans des conditions de référence correspondant à un état neuf de l'appareil de commutation.

L'ensemble d'actionnements de l'appareil de commutation réalisés dans des conditions de référence comprend par exemple 20 actionnements successifs de l'appareil de commutation.

Le procédé proposé comprend ainsi une phase de calibration permettant de quantifier les variations nominales de la valeur du polynôme du temps de réaction déterminé et de la grandeur représentative du courant circulant dans l'actionneur électromagnétique lors de l'actionnement de l'appareil de commutation. Ces variations nominales correspondent aux variations observées dans un état de référence dans lequel l'appareil de commutation ne présente ni défaut de fabrication ni usure.

L'état de référence correspond par exemple à un état neuf de l'appareil de commutation.

Le procédé proposé comprend une phase de mesure dans laquelle les variations de la valeur du polynôme du temps de réaction déterminé et de la grandeur représentative du courant circulant dans l'actionneur électromagnétique sont analysées.

La phase de mesure suit la phase de calibration.

La phase de mesure est réalisée tout au long de la durée d'utilisation de l'appareil de commutation.

Selon un mode de réalisation du procédé de détection, le paramètre statistique représentatif d'une fluctuation du polynôme du temps de réaction déterminé et de la grandeur déterminée est égal au rapport de :

- la différence entre une valeur courante du polynôme déterminée pour un actionnement courant et la valeur moyenne des valeurs du polynôme obtenues pour un nombre prédéterminé d'actionnements précédant l'actionnement courant, et de
- l'écart-type déterminé des valeurs du polynôme du temps de réaction déterminé et de la grandeur déterminée, déterminé pour un ensemble d'actionnements de l'appareil de commutation réalisés dans des conditions de référence correspondant à un état neuf de l'appareil de commutation.

Le paramètre statistique proposé permet une détection robuste d'une éventuelle dégradation de l'actionneur électromagnétique, tout en étant simple à mettre en œuvre. En particulier, les calculs nécessaires sont facilement réalisables en temps réel, ce qui permet une détection rapide d'une éventuelle dégradation.

Selon un mode de réalisation du procédé de détection, le paramètre statistique représentatif d'une fluctuation du polynôme du temps de réaction déterminé et de la grandeur déterminée est égal à :

[Math. 1]

$$D_i = \frac{P_i - \frac{\sum_{j=i-M-1}^{j=i-1} P_j}{M}}{\sqrt{\sum_{j=1}^{K}(\frac{P_j - \frac{\sum_{j=1}^{j=K} P_j}{K}}{K})^2}}$$

Avec $P_i$ la valeur déterminée du polynôme pour un actionnement de rang i,

$D_i$ la valeur calculée du paramètre statistique pour l'actionnement de rang i,

M un nombre d'actionnements pris en compte pour déterminer une valeur moyenne,

K un nombre d'actionnements réalisés dans des conditions de référence correspondant à un état neuf de l'appareil de commutation.

Selon un exemple de mise en œuvre du procédé de détection, une dégradation de l'actionneur électromagnétique est déterminée lorsque la valeur absolue du paramètre statistique représentatif d'une fluctuation du polynôme du temps de réaction déterminé et de la grandeur déterminée est supérieur à un premier seuil prédéterminé positif.

La valeur choisie pour le premier seuil prédéterminé positif permet d'ajuster la sensibilité du procédé de détection proposé.

Le premier seuil prédéterminé positif est par exemple compris entre 2 et 3.

A l'inverse, une absence de dégradation de l'actionneur électromagnétique est déterminée lorsque la valeur absolue du paramètre statistique représentatif d'une fluctuation du polynôme du temps de réaction déterminé et de la grandeur déterminée est inférieure ou égale au premier seuil prédéterminé positif.

Autrement dit, une dégradation est déterminée lorsque la valeur absolue du paramètre statistique prend une valeur supérieure à une valeur seuil prédéfinie. A l'inverse, une absence de dégradation est déterminée lorsque la valeur absolue du paramètre statistique prend une valeur inférieure à la valeur seuil prédéfinie.

Selon un exemple de réalisation du procédé de détection, la dégradation de l'actionneur électromagnétique est classifiée en un premier type de dégradation, dit dégradation mineure, lorsque la valeur absolue du paramètre statistique représentatif d'une fluctuation du polynôme du temps de réaction déterminé et de la grandeur déterminée est supérieure à un premier seuil prédéterminé positif et inférieure à un deuxième seuil prédéterminé positif.

Le deuxième seuil prédéterminé positif est par exemple compris entre 4 et 5.

Selon un exemple de réalisation du procédé de détection, la dégradation de l'actionneur électromagnétique est classifiée en un deuxième type de dégradation, dit dégradation majeure, lorsque la valeur absolue du paramètre statistique représentatif d'une fluctuation du polynôme du temps de réaction déterminé et de la grandeur déterminée est supérieure au deuxième seuil prédéterminé positif.

Le paramètre statistique utilisé permet ainsi une quantification de la sévérité de la dégradation, et non uniquement la présence ou l'absence de dégradation.

Le procédé de détection peut comprendre une étape d'émission d'un signal d'alerte en réponse à une détermination d'une dégradation de l'actionneur électromagnétique.

Le signal d'alerte émis permet aux utilisateurs de planifier et de réaliser une opération de maintenance ou de remplacement de l'appareil de commutation lorsque celui-ci est dans un état dégradé, voire défectueux.

Aucun signal d'alerte n'est émis lorsqu'aucune dégradation n'a été déterminé. Autrement dit, aucune alerte n'est émise lorsque le procédé proposé indique que l'actionneur électromagnétique est exempt de dégradation.

L'invention se rapporte également à un appareil de commutation comportant :

- un actionneur électromagnétique configuré pour déverrouiller un mécanisme de commande comprenant un organe élastique configuré pour déplacer un contact électrique de façon à ouvrir ou fermer un circuit électrique,
- une unité électronique de contrôle configurée pour mettre en œuvre le procédé de détection de dégradation tel que décrit précédemment.

Selon un mode de réalisation, l'appareil de commutation comporte :

- un circuit de commande configuré pour faire circuler un courant électrique dans l'actionneur électromagnétique,
- un capteur de mesure du courant circulant dans l'actionneur électromagnétique.

**Brève description des dessins**

D'autres caractéristiques, détails et avantages apparaîtront à la lecture de la description détaillée ci-après, et à l'analyse des dessins annexés, sur lesquels :

[Fig. 1] est une vue schématique d'un circuit électrique équipé d'un appareil de commutation, le circuit électrique étant en position ouverte,

[Fig. 2] est une vue schématique d'un circuit électrique équipé d'un appareil de commutation, le circuit électrique étant en position fermée,

[Fig. 3] est une courbe d'évolution temporelle du courant dans un actionneur électromagnétique d'un appareil de commutation, lors de l'actionnement de celui-ci,

[Fig. 4] représente l'évolution de la courbe de la figure 3, au cours du vieillissement de l'appareil de commutation,

[Fig. 5] est un schéma temporel illustrant le procédé selon l'invention,

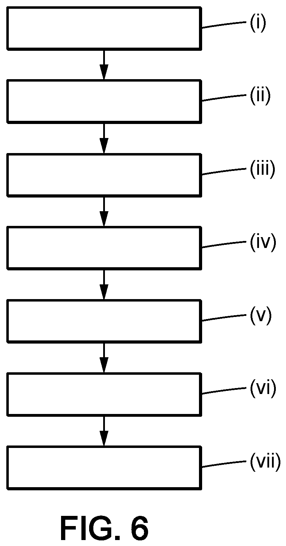

[Fig. 6] est un schéma-bloc illustrant différentes étapes du procédé selon l'invention.

**Description des modes de réalisation** :

Afin de faciliter la lecture des figures, les différents éléments ne sont pas nécessairement représentés à l'échelle. Sur ces figures, les éléments identiques portent les mêmes références. Certains éléments ou paramètres peuvent être indexés, c'est-à-dire désignés par exemple par premier élément ou deuxième élément, ou encore premier paramètre et second paramètre, etc. Cette indexation a pour but de différencier des éléments ou paramètres similaires, mais non identiques. Cette indexation n'implique pas une priorité d'un élément, ou paramètre par rapport à un autre et on peut interchanger les dénominations. Quand il est précisé qu'un sous-système comporte un élément donné, cela n'exclut pas la présence d'autres éléments dans ce sous-système. De même, quand il est précisé qu'un sous-système comprend un élément donné, il est entendu que le sous-système comprend au moins cet élément.

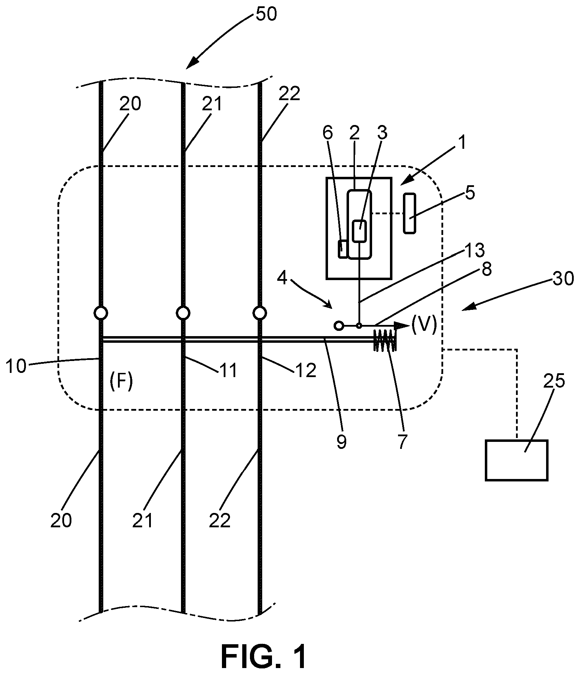

On a représenté schématiquement sur la figure 1 un circuit électrique 50. Le circuit électrique 50 comporte trois conducteurs électriques 20, 21, 22, chaque conducteur correspondant à une phase d'un réseau triphasé moyenne tension.

Le circuit électrique 50 comprend un appareil de commutation 30.
L'appareil de commutation 30 peut être un disjoncteur.
Selon une variante, l'appareil de commutation 30 peut être un interrupteur.
Selon un autre exemple d'application, l'appareil de commutation 30 peut être un sectionneur.

L'appareil de commutation 30 comporte :

- un actionneur électromagnétique 1 configuré pour déverrouiller un mécanisme de commande 4 comprenant un organe élastique 7 configuré pour déplacer un contact électrique mobile 10 de façon à ouvrir ou fermer un circuit électrique 50,
- une unité électronique de contrôle 25 configurée pour mettre en œuvre le procédé de détection de dégradation qui va être décrit en détail ci-dessous.

L'actionneur électromagnétique 1 est un électroaimant.
L'actionneur électromagnétique 1 comprend une bobine de commande 2 et un noyau magnétique 3 configuré pour se déplacer sous l'action d'un champ magnétique créé par une circulation de courant électrique dans la bobine de commande 2.

Le noyau magnétique 3 est par exemple mobile en translation.
Le noyau magnétique 3 est mécaniquement couplé à un organe de déverrouillage 8 configuré pour passer d'une position de verrouillage V dans laquelle l'organe élastique 7 est maintenu dans un état de tension à une position de libération L dans laquelle l'organe élastique 7 est libre de se détendre de façon à déplacer le contact électrique 10 de la position de fermeture F à la position d'ouverture O.

Le contact électrique mobile 10 est associé au conducteur électrique 20. De la même manière, un contact électrique mobile 11 est associé au conducteur électrique 21, et un contact électrique mobile 12 est associé au conducteur électrique 22.
Sur la figure 1, le contact électrique mobile 10 est représenté en position ouverte, c'est-à-dire dans la position où la circulation du courant électrique dans le circuit électrique 50 est interrompue.

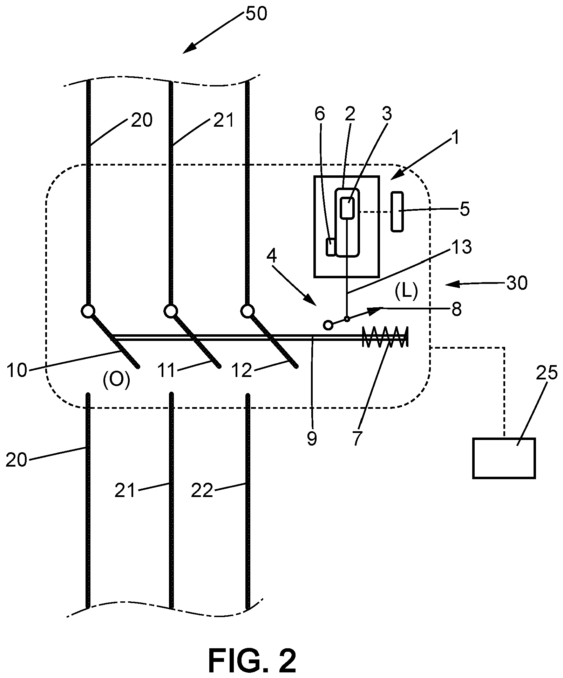

Sur la figure 2, le contact électrique mobile 10 est représenté en position fermée, c'est-à-dire dans la position où la circulation du courant électrique dans le circuit électrique 50 est possible.

L'actionneur électromagnétique 1 comprend un élément de couplage 13 couplant mécaniquement le noyau magnétique 3 à l'organe de déverrouillage 8.
Le mécanisme de commande 4 peut comprendre des éléments mobiles en rotation. Le mécanisme de commande 4 peut comprendre des éléments mobiles en translation.
Le mécanisme de commande 4 peut déplacer conjointement les trois contacts électriques mobiles 10, 11, 12.

L'actionneur électromagnétique 1 est configuré pour déclencher un déplacement du contact électrique mobile 10 afin d'ouvrir le circuit électrique 50.
Lorsque l'appareil de commutation 30 est un disjoncteur, l'actionneur électromagnétique 1 est configuré pour déclencher une ouverture du circuit électrique 50 en cas de présence d'un défaut sur le circuit électrique 50.
Un exemple de défaut pouvant être présent sur le circuit électrique 50 est un court-circuit entre deux phases distinctes. Un autre type de défaut peut être un court-circuit entre une phase et la terre.

L'appareil de commutation 30 comprend :

- un contact électrique 10 mobile entre une position d'ouverture O d'un circuit électrique 50 et une position de fermeture F du circuit électrique 50,
- un mécanisme de commande 4 comprenant :

    -- un organe élastique 7 configuré pour déplacer le contact électrique 10 de la position de fermeture F à la position d'ouverture O ou de la position d'ouverture O à la position de fermeture F, de façon à respectivement ouvrir ou fermer le circuit électrique 50,
    -- un organe de déverrouillage 8 configuré pour passer d'une position de verrouillage V dans laquelle l'organe élastique 7 est maintenu dans un état de tension à une position de libération L dans laquelle l'organe élastique 7 est libre de se détendre de façon à déplacer le contact électrique 10 de la position de fermeture F à la position d'ouverture O ou de la position d'ouverture O à la position de fermeture F,

- un actionneur électromagnétique 1 configuré pour déplacer l'organe de déverrouillage 8 de la position de verrouillage V à la position de libération L.

Selon le mode de réalisation illustré sur la figure 1 et la figure 2 :

- l'organe élastique 7 est configuré pour déplacer le contact électrique 10 de la position de fermeture F à la position d'ouverture O de façon à ouvrir le circuit électrique 50, et
- l'organe de déverrouillage 8 est configuré pour passer d'une position de verrouillage V dans laquelle l'organe élastique 7 est maintenu dans un état de tension à une position de libération L dans laquelle l'organe élastique 7 est libre de se détendre de façon à déplacer le contact électrique 10 de la position de fermeture F à la position d'ouverture O.

Autrement dit, le mécanisme de commande 4 permet de couper la circulation du courant dans le circuit électrique 50.

Selon un autre mode de réalisation, non représenté :

- l'organe élastique 7 est configuré pour déplacer le contact électrique 10 de la position d'ouverture O à la position de fermeture F, de façon à fermer le circuit électrique 50,
- l'organe de déverrouillage 8 est configuré pour passer d'une position de verrouillage V dans laquelle l'organe élastique 7 est maintenu dans un état de tension à une position de libération L dans laquelle l'organe élastique 7 est libre de se détendre de façon à déplacer le contact électrique 10 de la position d'ouverture O à la position de fermeture F.

Autrement dit, le mécanisme de commande 4 dans ce cas permet d'établir la circulation du courant dans le circuit électrique 50.

L'organe élastique 7 est configuré pour appliquer une force d'entrainement sur le contact électrique 10 mobile. L'organe élastique 7 peut être un ressort, par exemple un ressort spiral ou un ressort hélicoïdal.

L'organe élastique 7 est lié à un élément d'entrainement 9 configuré pour déplacer le contact électrique mobile 10 de façon à ouvrir ou fermer un circuit électrique 50. L'élément d'entrainement 9 comprend par exemple une biellette de liaison.

Selon le mode de réalisation illustré sur la figure 1 et la figure 2, l'organe de déverrouillage 8 peut passer d'une position de verrouillage dans laquelle l'organe élastique 7 du mécanisme de commande 4 est élastiquement contraint et dans laquelle le contact électrique mobile 10 est en position de fermeture F du circuit électrique 50, à une position déverrouillée V dans laquelle l'organe élastique 7 du mécanisme de commande 4 est libéré et déplace le contact électrique mobile 10 de la position de fermeture F du circuit électrique 50 à une position d'ouverture O du circuit électrique 50.

Selon le deuxième mode de réalisation, non illustré, l'organe de déverrouillage 8 peut passer d'une position de verrouillage dans laquelle l'organe élastique 7 du mécanisme de commande 4 est élastiquement contraint et dans laquelle le contact électrique mobile 10 est en position d'ouverture O du circuit électrique 50, à une position déverrouillée V dans laquelle l'organe élastique 7 du mécanisme de commande 4 est libéré et déplace le contact électrique mobile 10 d'une position d'ouverture O du circuit électrique 50 à la position de fermeture F du circuit électrique 50.

On entend par déverrouiller le mécanisme de commande 4 le fait de libérer l'organe élastique 7 du mécanisme de commande 4.

L'électroaimant 1 permet de commander le déplacement de l'organe de déverrouillage 8 de façon à libérer l'organe élastique 7.

La force propulsive permettant de déplacer le contact électrique mobile 10 est fournie par l'organe élastique 7. L'actionneur électromagnétique 1 n'a pas d'interaction directe avec le contact électrique mobile 10. L'actionneur électromagnétique 1 fournit une force d'origine électromagnétique permettant le déplacement de l'organe de déverrouillage 8, par l'intermédiaire de l'élément de couplage 13. Une fois que l'organe de déverrouillage 8 est en position déverrouillée V, l'énergie potentielle stockée par l'organe élastique 7 est libérée et assure le déplacement du contact électrique 10 par l'intermédiaire de l'élément d'entrainement 9.

Sur la figure 1, L'organe de déverrouillage 8 est en position de verrouillage V et l'organe élastique 7, schématisé comme un ressort hélicoïdal, est maintenu à l'état comprimé. Le contact mobile 10 est en position fermée, correspondant à une circulation du courant électrique dans le conducteur électrique 20.

Sur la figure 2, l'élément de couplage 13 a déplacé l'organe de déverrouillage 8 en position de libération. L'organe élastique 7 est à l'état détendu, et l'élément d'entrainement 9 a déplacé le contact électrique mobile 10 jusqu'à sa position d'ouverture, correspondant à une interruption du passage du courant dans le conducteur électrique 20 et donc dans le circuit électrique 50.

Les composants mécaniques de l'appareil de commutation 30 peuvent se dégrader au cours de la durée de vie d'utilisation de l'appareil de commutation, en raison notamment de l'usure résultant de la répétition des déclenchements, des déformations et de la corrosion chimique pouvant intervenir.

Il est donc souhaitable de pouvoir disposer d'une méthode de diagnostic de l'appareil de commutation 30, c'est-à-dire une méthode permettant de détecter l'apparition d'une dégradation de l'appareil de commutation 30.

Il est ainsi proposé un procédé de détection d'une dégradation d'un appareil de commutation 30 comprenant un actionneur électromagnétique 1 configuré pour déverrouiller un mécanisme de commande 4 comprenant un organe élastique 7 configuré pour déplacer un contact électrique mobile 10 de façon à ouvrir ou fermer un circuit électrique 50, le procédé comprenant les étapes :

(i) commander l'actionneur électromagnétique 1,

(ii) mesurer un courant C circulant dans l'actionneur électromagnétique 1 lors de la commande de l'actionneur électromagnétique 1,

(iii) déterminer à partir du courant C mesuré un temps de réaction ta de l'actionneur électromagnétique 1,

(iv) déterminer à partir du courant C mesuré une grandeur i1 représentative du courant circulant dans l'actionneur électromagnétique 1 lors de la commande de l'actionneur électromagnétique 1,

(v) déterminer un paramètre P sous la forme d'un polynôme du temps de réaction déterminé ta et de la grandeur déterminée i1 représentative du courant circulant dans l'actionneur électromagnétique 1 lors de la commande de l'actionneur électromagnétique 1,

(vi) itérer les étapes (i) à (v) pour un ensemble de commande successives de l'actionneur électromagnétique 1 de façon à obtenir un ensemble E de valeurs du paramètre déterminé P,

(vii) déterminer une dégradation de l'actionneur électromagnétique 1 à partir de l'évolution des valeurs de l'ensemble E au cours des commandes successives de l'actionneur électromagnétique 1.

Dans le cas où l'actionneur électromagnétique 1 fonctionne de façon nominale, les valeurs de l'ensemble E n'évoluent sensiblement pas au cours des actionnements successifs. Autrement dit, les différentes valeurs de l'ensemble E sont sensiblement constantes. A l'inverse, une dégradation progressive de l'actionneur électromagnétique 1 a tendance à provoquer une évolution des valeurs de l'ensemble E au cours des actionnements successifs. Les valeurs de l'ensemble E ne sont plus sensiblement constantes et présentent une évolution significative. Cette évolution progressive permet de détecter une dégradation de l'appareil de commutation 30, ainsi que la présence d'un défaut.

L'ensemble E de valeurs du polynôme P du temps de réaction déterminé ta et de la grandeur déterminée i1 est obtenu par une succession de commandes consécutives de l'actionneur électromagnétique 1 de l'appareil de commutation 30.

Chaque valeur de l'ensemble E de valeurs du polynôme P du temps de réaction déterminé ta et de la grandeur déterminée i1 correspond à un actionnement distinct de l'actionneur électromagnétique 1 de l'appareil de commutation 30. En d'autres termes, une valeur du temps de réaction ta est associée à chacun des différents actionnements de l'appareil de commutation 30. De la même manière, une valeur du paramètre déterminé i1 est associée à chacun des différents actionnements de l'appareil de commutation 30. Une valeur du polynôme P de ta et i1 est associée à chacun des actionnements de l'appareil de commutation 30.

L'appareil de commutation 30 comporte :

- un circuit de commande 5 configuré pour faire circuler un courant électrique dans actionneur électromagnétique 1,
- un capteur 6 de mesure du courant circulant dans l'actionneur électromagnétique 1.

On entend par mesurer un courant C circulant dans l'actionneur électromagnétique 1 le fait de mesurer l'intensité du courant électrique circulant dans l'actionneur électromagnétique 1.

Plus précisément, l'intensité du courant électrique circulant dans la bobine de commande 2 est mesurée.

Pour cela, le courant C circulant dans l'actionneur électromagnétique 1 est détecté par un circuit électronique de mesure.

Dans l'exemple illustré, le courant C circulant dans l'actionneur électromagnétique 1 est échantillonné, par exemple avec une fréquence d'échantillonnage comprise entre 1 kHz et 100 kHz.

Autrement dit, la valeur du courant est mesurée périodiquement pendant une phase d'actionnement de l'actionneur électromagnétique 1.

Le temps de réaction ta de l'actionneur électromagnétique 1 est déterminé à partir des variations temporelles du courant C mesuré.

Le procédé proposé comprend ainsi une sous-étape de détermination des variations temporelles du courant C mesuré.

Aucun capteur autre que le capteur de mesure du courant n'est nécessaire pour déterminer le temps de réaction ta de l'actionneur électromagnétique 1. En particulier, il n'est pas nécessaire de disposer d'un capteur de déplacement d'un élément du mécanisme de commande 4 liant le contact électrique mobile 10 à l'actionneur électromagnétique 1.

Selon un aspect du procédé de détection proposé, le temps de réaction ta de l'actionneur électromagnétique 1 est égal à une durée écoulée entre un instant t0 de début de circulation du courant électrique dans l'actionneur électromagnétique 1 et un instant tmin correspondant à une valeur minimale locale du courant électrique circulant dans l'actionneur électromagnétique 1.

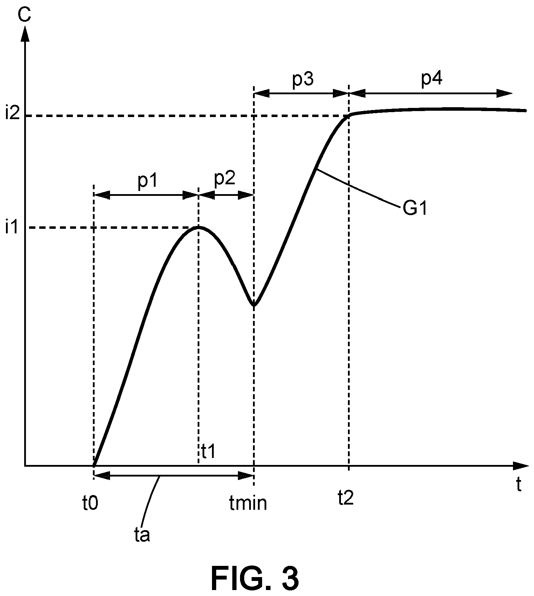

La figure 3 représente schématiquement une courbe d'évolution temporelle du courant électrique circulant dans l'actionneur électromagnétique 1 lorsque celui-ci est commandé. Cette courbe de l'intensité en fonction du temps est désignée par le signe G1.

La courbe G1 d'évolution temporelle du courant électrique dans l'actionneur électromagnétique 1 comprend une première portion p1 continument croissante, une deuxième portion p2 continument décroissante, la deuxième portion p2 suivant la première portion p1, une troisième portion p3 continument croissante, la troisième portion p3 suivant la deuxième portion p2. L'instant tmin correspondant au minimum local du courant correspond à l'instant séparant la troisième portion p3 de la deuxième portion p2.

L'instant t0 de début de circulation du courant électrique dans l'actionneur électromagnétique 1 correspond au début de la portion continument croissante p1. La première portion p1 comprend une première partie dans laquelle le courant augmente linéairement.

Puis, en s'approchant de l'instant t1 l'augmentation du courant devient moins rapide. A l'instant t1 le courant atteint sa valeur maximale depuis l'instant t0, puis le courant diminue. Cette diminution du courant est liée à l'évolution de l'entrefer entre les pièces mobiles et les pièces fixes.

Le courant diminue jusqu'à l'instant tmin, où il atteint sa valeur minimale depuis l'instant t1, puis réaugmente.

L'instant tmin correspond à la fin de la phase de déplacement du noyau magnétique 3.

Une fois que l'entrefer n'évolue plus, le courant recommence à augmenter, ce qui correspond à la portion p3 de la courbe G1.

La courbe d'évolution temporelle du courant électrique dans l'actionneur électromagnétique 1 comprend une quatrième portion p4 sensiblement constante, la quatrième portion P4 suivant la troisième portion p3.

Le courant permanent s'établit, à partir de l'instant indiqué par t2, à une valeur permanente i2.

La chute du courant lorsque la commande de la bobine 2 est interrompue n'est pas illustrée sur la figure 3.

Selon un mode de réalisation du procédé de détection, la grandeur i1 représentative du courant circulant dans l'actionneur électromagnétique 1 lors de l'actionnement de l'appareil de commutation 30 est une valeur maximale locale du courant électrique circulant dans l'actionneur électromagnétique 1.

Le paramètre i1 correspond à la valeur maximale du courant au cours de la phase de commande pendant laquelle le noyau magnétique 3 est en mouvement, qui s'étend entre l'instant t0 et l'instant tmin.

A l'étape (v), le paramètre P est déterminé par une somme de monômes à deux indéterminées. Une première indéterminée est le temps de réaction déterminé ta, et la deuxième indéterminée est la grandeur déterminée i1 représentative du courant circulant dans l'actionneur électromagnétique 1 lors de la commande de l'actionneur électromagnétique 1.

On a ainsi :

[Math. 4]

$$P = \sum_{i=0}^{H} M_i$$

Chaque monôme $M_i$ du polynôme est ainsi déterminé par le produit : du temps de réaction déterminé ta, élevé à une première puissance donnée $K_i$, et : de la grandeur déterminée i1 représentative du courant circulant dans l'actionneur électromagnétique 1 lors de la commande de l'actionneur électromagnétique 1, élevée à une deuxième puissance donnée $L_i$, et d'un coefficient constant $A_i$.

Chaque monôme $M_i$ peut s'écrire sous la forme :

[Math. 2]

$$M_i = A_i * (ta)^{k_i} * (i1)^{L_i}$$

Le polynôme formant le paramètre P peut ainsi s'écrire :

[Math. 3]

$$P = \sum_{i=0}^{H} A_i * (ta)^{k_i} * (i1)^{L_i}$$

avec les coefficients $k_0$, ..., $k_H$ prenant des valeurs rationnelles, les coefficients $L_0$, ..., $L_H$ prenant des valeurs rationnelles, et les coefficients $A_i$ prenant des valeurs rationnelles.

Le polynôme permettant de déterminer le paramètre P comprend, dans sa forme la plus générale, (H+1) monômes.

Parmi une multitude de paramètres étudiés, le déposant a conclu que le polynôme formé à partir du temps de réaction ta de l'actionneur électromagnétique 1 et de la valeur maximale locale i1 du courant dans l'actionneur électromagnétique 1 est la grandeur qui rend le mieux compte d'une dégradation progressive de cet actionneur électromagnétique.

Le polynôme est un polynôme à deux indéterminées, la première indéterminée étant la grandeur ta et la deuxième indéterminée étant la grandeur i1.

Selon un mode de réalisation particulier du procédé de détection proposé, le paramètre P est égal au produit du temps de réaction déterminé ta et de la grandeur déterminée i1 représentative du courant circulant dans l'actionneur électromagnétique 1 lors de la commande de l'actionneur électromagnétique 1.

Autrement dit, dans ce cas particulier de mise en œuvre du procédé, le polynôme P est un monôme, dont la première puissance $k_1$ est égale à 1 et la deuxième puissance $L_1$ est également égale à 1.

Le polynôme formé est alors égal au produit du temps de réaction déterminé ta et de la grandeur déterminée i1 représentative du courant circulant dans l'actionneur électromagnétique 1 lors de la commande de l'actionneur électromagnétique 1, c'est-à-dire au résultat de la multiplication ta * i1 de la valeur du temps de réaction déterminé ta par la valeur de la grandeur déterminée i1 représentative du courant circulant dans l'actionneur électromagnétique 1 lors de la commande de l'actionneur électromagnétique 1.

La valeur maximale locale i1 du courant est obtenue pour un instant t1 compris entre un instant t0 de début de circulation du courant électrique dans l'actionneur électromagnétique 1 et un instant tmin correspondant à un minimum local du courant électrique circulant dans l'actionneur électromagnétique 1.

La valeur maximale locale i1 du courant est la valeur du courant obtenue au passage de la première portion p1 à la deuxième portion p2.

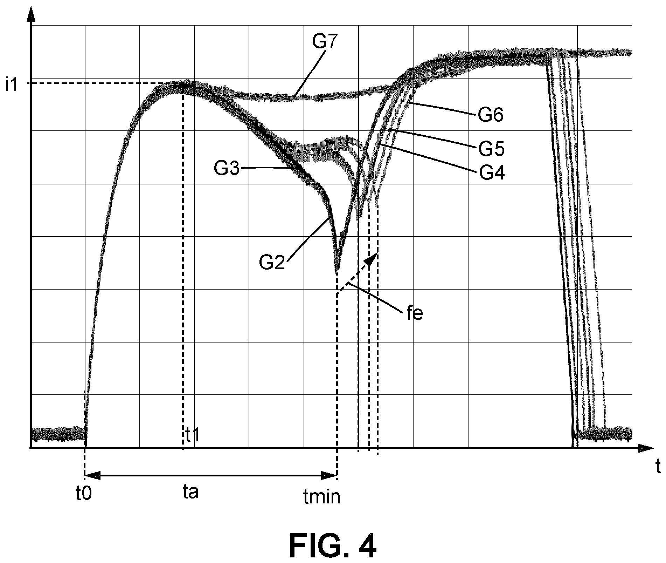

La figure 4 représente schématiquement l'évolution temporelle du courant électrique circulant dans l'actionneur électromagnétique 1 lorsque celui-ci est commandé, au cours d'un essai de vieillissement accéléré d'un appareil de commutation 30.

En particulier, la figure 4 illustre l'évolution des paramètres ta et i1 lors de cet essai de vieillissement accéléré. Un tel type d'essai est réalisé dans des conditions sévérisées par rapport à une utilisation normale de l'appareil de commutation, avec par exemple une température plus élevée et une atmosphère plus corrosive que dans les conditions normales.

La courbe G2 correspond à l'état initial en début d'essai, et les courbes G3, G4, ..., G7 correspondent à l'état après des durées croissantes d'essai.

Le temps tmin, correspondant à la fin de déplacement du noyau magnétique 3, se décale peu à peu vers des valeurs de plus en plus élevées. Le sens de variation est mis en évidence par la flèche fe. Ce décalage traduit un déplacement de plus en plus difficile des pièces mécaniques de l'appareil de commutation.

Sur la courbe G7, le courant est quasiment constant, ce qui montre que le noyau magnétique est quasiment bloqué dans son mouvement. Un tel état correspond à une défaillance de l'appareil de commutation.

Selon un mode de réalisation du procédé proposé, le procédé de détection comprend les sous-étapes :

- calculer une valeur d'un paramètre statistique D représentatif d'une fluctuation des valeurs de l'ensemble E de valeurs du polynôme du temps de réaction déterminé ta et du paramètre déterminé i1,
- déterminer une dégradation de l'actionneur électromagnétique 1 à partir de la valeur calculée du paramètre statistique D.

L'évolution des valeurs de l'ensemble E au cours des actionnements successifs est suivie de façon quantitative grâce à au paramètre statistique D.

Le paramètre statistique D représentatif d'une fluctuation des valeurs de l'ensemble E de valeurs du polynôme du temps de réaction déterminé ta et de la grandeur déterminée i1 comprend une différence d entre :

- une valeur courante du polynôme P du temps de réaction déterminé ta et de la grandeur déterminée i1, déterminée pour un actionnement courant de l'appareil de commutation 30, et
- une valeur moyenne Moy des valeurs du polynôme P du temps de réaction déterminé ta et de la grandeur déterminée i1 obtenues pour un nombre prédéterminé M d'actionnements précédant l'actionnement courant de l'appareil de commutation 30.

La valeur moyenne Moy peut être une moyenne glissante calculée à partir des M valeurs correspondant aux M actionnements précédent l'actionnement courant, et comprenant un nombre de valeurs égal au nombre prédéterminé M d'actionnements. L'actionnement courant n'est pas inclus dans le sous-ensemble de valeurs prises en compte pour le calcul de la valeur moyenne. Ce sous-ensemble comprend M valeurs.

Selon un exemple de mise en œuvre du procédé de détection, le paramètre statistique D représentatif d'une fluctuation des valeurs de l'ensemble E de valeurs du polynôme du temps de réaction déterminé ta et de la grandeur déterminée i1 comprend un écart-type des valeurs du polynôme du temps de réaction déterminé ta et de la grandeur déterminée i1 déterminé pour un ensemble d'actionnements de l'appareil de commutation 30 réalisés dans des conditions de référence correspondant à un état neuf de l'appareil de commutation 30.

On entend par écart-type d'un ensemble d'échantillons la grandeur égale à la racine carrée de la variance de cet ensemble d'échantillons. La variance est elle-même définie par l'espérance mathématique du carré des écarts à la moyenne, ou encore la moyenne quadratique des écarts entre les valeurs de l'ensemble d'échantillons et la moyenne de ces valeurs.

L'ensemble d'actionnements de l'appareil de commutation 30 réalisés dans des conditions de référence comprend par exemple 20 actionnements successifs de l'appareil de commutation.

Le procédé proposé comprend ainsi une phase de calibration permettant de quantifier les variations nominales de la valeur du polynôme du temps de réaction déterminé ta et de la grandeur i1 représentative du courant circulant dans l'actionneur électromagnétique 1 lors de l'actionnement de l'appareil de commutation 30. Ces variations nominales correspondent aux variations observées dans un état de référence dans lequel de l'appareil de commutation 30 ne présente aucune dégradation.

L'état de référence correspond par exemple à un état neuf de l'appareil de commutation 30.

On entend par état neuf une période démarrant au premier actionnement de l'appareil de commutation, durant une durée maximale prédéterminée et comprenant un nombre maximal prédéterminé d'actionnements. Autrement dit, l'état neuf correspond à une période temporelle.

Les valeurs acquises dans ces conditions de référence permettent de déterminer la variabilité nominale de la quantité égale au polynôme du temps de réaction déterminé ta et de la grandeur déterminée i1. Cette variabilité est ici caractérisée par la grandeur mathématique égale à l'écart-type de la quantité égale au polynôme du temps de réaction déterminé ta et de la grandeur déterminée i1, déterminée pour les actionnements correspondant à la phase de calibration. Cette variabilité est caractérisée à partir d'un nombre prédéterminé K de valeurs correspondant à un nombre prédéterminé d'actionnements. Par exemple, K=20 actionnements successifs réalisés à l'état neuf de l'appareil de commutation peuvent permettre de caractériser la variabilité initiale de la quantité utilisée pour déterminer une dégradation de l'appareil de commutation 30.

Le procédé proposé comprend une phase de mesure dans laquelle les variations de la valeur du polynôme du temps de réaction déterminé ta et de la grandeur i1 représentative du courant circulant dans l'actionneur électromagnétique 1 sont analysées.

La phase de mesure suit la phase de calibration.

La phase de mesure est par exemple réalisée tout au long de la durée d'utilisation de l'appareil de commutation 30.

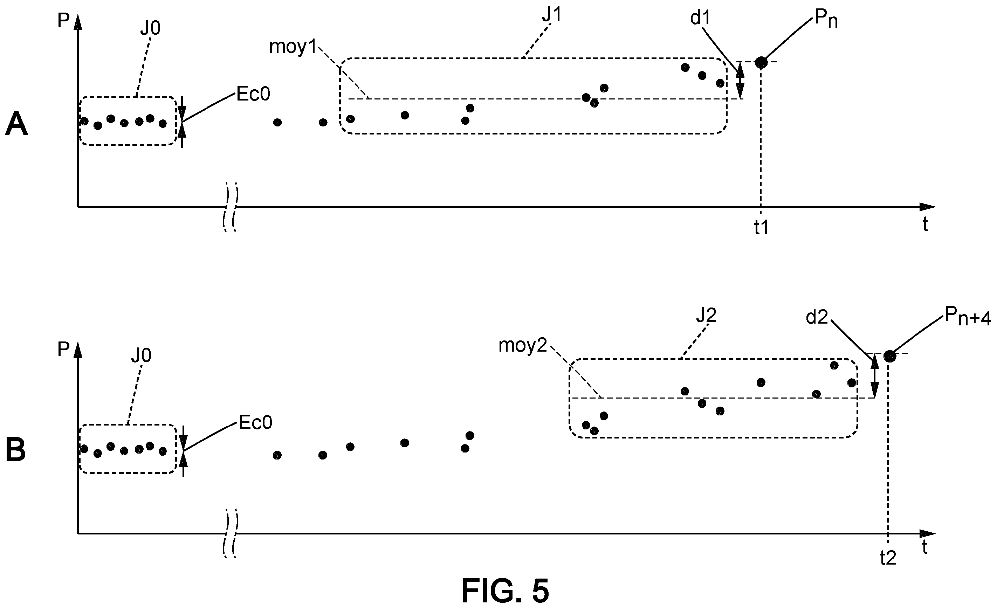

La figure 5 illustre les valeurs de la quantité P égale au polynôme du temps de réaction déterminé ta et de la grandeur déterminée i1, pour différents actionnements.

La partie A schématise les mesures réalisées à un premier instant t1. La partie B de la figure schématise les mesures réalisées à un deuxième instant t2, qui est postérieur à t1.

Les points de mesure encadrés par le cadre désigné par J0 sont ceux réalisés dans des conditions de référence correspondant à un état neuf de l'appareil de commutation 30. Pour simplifier la figure, seuls 7 points de mesure ont été représentés. On peut remarquer que la dispersion des valeurs de la quantité P est faible.

Le signe Ec0 désigne l'écart-type des valeurs correspondant à l'ensemble d'actionnements de l'appareil de commutation 30 réalisés dans des conditions de référence, et prises en compte pour la phase de calibration.

Sur l'exemple représenté, les valeurs prises en compte pour la détermination de l'écart-type de référence correspondent à des actionnements consécutifs de l'actionneur électromagnétique 1. Il est aussi possible que les valeurs ne correspondent pas à des actionnements consécutifs, c'est-à-dire que certains actionnements peuvent ne pas être pris en compte.

Sur la partie A de la figure 5, les points de mesure encadrés par le cadre désigné par J1 sont les points utilisés à l'instant t1 pour la phase de mesure. Comme précédemment, pour simplifier la figure seuls 10 points de mesure de la grandeur P ont été représentés.

La valeur $P_n$, déterminée au temps t1, est la valeur courant à l'instant t1, c'est-à-dire la valeur la plus récente, correspondant à la commande la plus récente de l'actionneur électromagnétique 1.

Le trait horizontal en pointillés indique la valeur moyenne moy1 des valeurs prises en compte, c'est-à-dire celles présentes dans le cadre J1.

La flèche désignée par d1 illustre l'écart d1 entre la valeur courante $P_n$ et la valeur moyenne moy1 calculée sur l'exemple de la figure 5 sur les 10 points de mesure précédant la mesure courante.

Sur la partie B de la figure 5, les points de mesure encadrés par le cadre désigné par J2 sont les points utilisés à l'instant t2 pour la phase de mesure. Comme précédemment, 10 points de mesure sont utilisés sur la figure.

La valeur déterminée au temps t2, est la valeur courante à l'instant t2, c'est-à-dire la valeur la plus récente. Par rapport à l'instant t1, 4 nouvelles mesures ont été acquises, et les 4 valeurs les plus anciennes du cadre J1 ne sont pas utilisées à l'instant t2 et ne font pas partie du cadre J2.

Le trait horizontal en pointillés indique la valeur moyenne moy2 des valeurs prises en compte, c'est-à-dire celles présentes dans le cadre J2.

La flèche désignée par d2 illustre l'écart d2 entre la valeur courante $P_{n+4}$ et la valeur moyenne moy2.

Selon un mode de réalisation du procédé de détection, le paramètre statistique D représentatif d'une fluctuation du polynôme du temps de réaction déterminé ta et de la grandeur déterminée i1 est égal au rapport de :

- la différence d entre une valeur courante du polynôme P déterminée pour un actionnement courant et la valeur moyenne Moy des valeurs du polynôme P obtenues pour un nombre prédéterminé M d'actionnements précédant l'actionnement courant, et de
- l'écart-type déterminé des valeurs du polynôme du temps de réaction déterminé ta et de la grandeur déterminée i1, déterminé pour un ensemble d'actionnements de l'appareil de commutation 30 réalisés dans des conditions de référence correspondant à un état neuf de l'appareil de commutation 30.

Le paramètre statistique D proposé permet une détection robuste d'une dégradation de l'actionneur électromagnétique 1, tout en étant simple à mettre en œuvre. En particulier, les calculs nécessaires sont facilement réalisables en temps réel, ce qui permet une détection également en temps réel de la présence d'une dégradation.

Le paramètre statistique D représentatif d'une fluctuation du polynôme du temps de réaction déterminé ta et de la grandeur déterminée i1 est ainsi égal, pour une mesure de rang i, à :

[Math. 1]

$$D_i = \frac{P_i - \frac{\sum_{j=i-M-1}^{j=i-1} P_j}{M}}{\sqrt{\sum_{j=1}^{K}\left(\frac{P_j - \frac{\sum_{j=1}^{j=K} P_j}{K}}{K}\right)^2}}$$

Avec $P_i$ la valeur déterminée du polynôme P pour un actionnement de rang i, $D_i$ la valeur calculée du paramètre statistique D pour l'actionnement de rang i,

M le nombre d'actionnements pris en compte pour la détermination de la valeur moyenne,

K est un nombre d'actionnements réalisés dans des conditions de référence correspondant à un état neuf de l'appareil de commutation 30. C'est-à-dire que K est le nombre d'actionnements pris en compte pour la calibration initiale

Une dégradation de l'actionneur électromagnétique 1 est déterminée lorsque la valeur absolue du paramètre statistique D représentatif d'une fluctuation du polynôme du temps de réaction déterminé ta et de la grandeur déterminée i1 est supérieure à un premier seuil prédéterminé positif S1.

Par définition, la valeur absolue d'un nombre donné est sa valeur numérique sans tenir compte de son signe.

Si un nombre est positif, sa valeur absolue est ainsi égale à ce nombre.

Si un nombre est négatif, sa valeur absolue est égale à l'opposé de ce nombre.

On dit qu'une dégradation est déterminée lorsqu'une dégradation est détectée.

La valeur choisie pour le premier seuil prédéterminé positif S1 permet d'ajuster la sensibilité du procédé de détection proposé.

Le premier seuil prédéterminé positif S1 est par exemple compris entre 2 et 3.

Plus le seuil choisi est proche de 1, plus la détection de défaut sera sensible, c'est-à-dire qu'une faible déviation par rapport aux conditions de référence sera interprétée comme l'apparition d'une dégradation.

A l'inverse, une absence de dégradation de l'actionneur électromagnétique 1 est déterminée lorsque la valeur absolue du paramètre statistique D représentatif d'une fluctuation du polynôme du temps de réaction déterminé ta et de la grandeur déterminée i1 est inférieure ou égale au premier seuil prédéterminé positif S1.

Une faible valeur de la valeur absolue du paramètre statistique D, indiquant un faible écart entre le comportement actuel de l'actionneur électromagnétique 1 et son comportement à l'état neuf, indique un état de fonctionnement proche de l'état neuf. Une absence de dégradation peut ainsi être confirmée.

Selon un exemple de réalisation du procédé de détection, la dégradation de l'actionneur électromagnétique 1 est classifié en un premier type de dégradation, dit dégradation mineure, lorsque la valeur absolue du paramètre statistique D représentatif d'une fluctuation du polynôme du temps de réaction déterminé ta et de la grandeur déterminée i1 est supérieure à un premier seuil prédéterminé positif S1 et inférieure à un deuxième seuil prédéterminé positif S2.

Le deuxième seuil prédéterminé positif S2 est par exemple compris entre 4 et 5.

Selon un exemple de réalisation du procédé de détection, la dégradation de l'actionneur électromagnétique 1 est classifiée en un deuxième type de dégradation, dit dégradation majeure, lorsque la valeur absolue du paramètre statistique D représentatif d'une fluctuation du polynôme du temps de réaction déterminé ta et de la grandeur déterminée

i1 est supérieure au deuxième seuil prédéterminé positif S2.

On notera que le procédé proposé peut être mis en œuvre sans réaliser un calcul direct de la valeur absolue du paramètre statistique D. En effet, la valeur déterminée du paramètre statistique D peut être comparée d'une part aux valeurs seuils S1, S2, qui sont positives, et d'autre part à l'opposé -S1, -S2 de ces valeurs seuils. Une éventuelle dégradation peut être déterminée sur la base de cette double comparaison.

Le paramètre statistique D utilisé permet ainsi une quantification de la sévérité de la dégradation, et non uniquement une détermination de la présence ou l'absence d'une dégradation. Les opérateurs du circuit électrique 50 sur lequel l'appareil de commutation est utilisé peuvent ainsi suivre l'évolution de l'appareil au cours du temps, et réagir en conséquence.

Le procédé de détection peut comprendre une étape d'émission d'un signal d'alerte en réponse à une détermination d'une dégradation de l'actionneur électromagnétique 1.

Le signal d'alerte peut être par exemple un code mémorisé dans une unité électronique de contrôle. En variante ou de manière complémentaire, le signal d'alerte peut être un allumage d'un voyant.

En variante encore ou en complément, le signal d'alerte peut être un affichage d'un message sur un écran de contrôle.

D'autres types d'alerte sont bien sur possibles.

Le signal d'alerte émis peut être différent lorsque la dégradation détectée est une dégradation dite mineure et lorsque la dégradation détectée est une dégradation dite majeure.

Le signal d'alerte émis permet aux utilisateurs de planifier et de réaliser une opération de maintenance ou de remplacement l'appareil de commutation dégradé, afin de corriger le problème diagnostiqué.

Aucun signal d'alerte n'est émis lorsqu'aucune dégradation n'a été déterminée. Autrement dit, aucune alerte n'est émise lorsque le procédé proposé indique que l'actionneur électromagnétique 1 est exempt de dégradation.

## Revendications

1. Procédé de détection d'une dégradation d'un appareil de commutation (30) comprenant un actionneur électromagnétique (1) configuré pour déverrouiller un mécanisme de commande (4) comprenant un organe élastique (7) configuré pour déplacer un contact électrique mobile (10) de façon à ouvrir ou fermer un circuit électrique (50), le procédé comprenant les étapes :

   (i) commander l'actionneur électromagnétique (1),
   (ii) mesurer un courant (C) circulant dans l'actionneur électromagnétique (1) lors de la commande de l'actionneur électromagnétique (1), **caractérisé par**
   (iii) déterminer à partir du courant (C) mesuré un temps de réaction (ta) de l'actionneur électromagnétique (1),
   (iv) déterminer à partir du courant (C) mesuré une grandeur (i1) représentative du courant circulant dans l'actionneur électromagnétique (1) lors de la commande de l'actionneur électromagnétique (1),
   (v) déterminer un paramètre (P) sous la forme d'un polynôme du temps de réaction déterminé (ta) et de la grandeur déterminée (i1) représentative du courant circulant dans l'actionneur électromagnétique (1) lors de la commande de l'actionneur électromagnétique (1), le paramètre (P) s'écrivant :

$$P = \sum_{i=0}^{H} A_i * (ta)^{k_i} * (i1)^{L_i}$$

   avec :

      les coefficients $k_0, ..., k_H$ prenant des valeurs rationnelles,
      les coefficients $L_0, ..., L_H$ prenant des valeurs rationnelles,
      et les coefficients $A_i$ prenant des valeurs rationnelles,

   (vi) itérer les étapes (i) à (v) pour un ensemble de commande successives de l'actionneur électromagnétique (1) de façon à obtenir un ensemble (E) de valeurs du paramètre déterminé (P),
   (vii) déterminer une dégradation de l'actionneur électromagnétique (1) à partir de l'évolution des valeurs de l'ensemble (E) au cours des commandes successives de l'actionneur électromagnétique (1).

2. Procédé de détection selon la revendication 1, dans lequel l'appareil de commutation (30) comprend :

- un contact électrique (10) mobile entre une position d'ouverture (O) d'un circuit électrique (50) et une position de fermeture (F) du circuit électrique (50),
- un mécanisme de commande (4) comprenant :

-- un organe élastique (7) configuré pour déplacer le contact électrique (10) de la position de fermeture (F) à la position d'ouverture (O) ou de la position d'ouverture (O) à la position de fermeture (F), de façon à respectivement ouvrir ou fermer le circuit électrique (50),

-- un organe de déverrouillage (8) configuré pour passer d'une position de verrouillage (V) dans laquelle l'organe élastique (7) est maintenu dans un état de tension à une position de libération (L) dans laquelle l'organe élastique (7) est libre de se détendre de façon à déplacer le contact électrique (10) de la position de fermeture (F) à la position d'ouverture (O) ou de la position d'ouverture (O) à la position de fermeture (F),

- un actionneur électromagnétique (1) configuré pour déplacer l'organe de déverrouillage (8) de la position de verrouillage (V) à la position de libération (L).

3. Procédé de détection selon la revendication 1 ou 2, dans lequel le paramètre (P) est égal au produit du temps de réaction déterminé (ta) et de la grandeur déterminée (i1) représentative du courant circulant dans l'actionneur électromagnétique (1) lors de la commande de l'actionneur électromagnétique (1).

4. Procédé de détection selon l'une des revendications précédentes, dans lequel le temps de réaction (ta) de l'actionneur électromagnétique (1) est déterminé à partir des variations temporelles du courant (C) mesuré.

5. Procédé de détection selon l'une des revendications précédentes, dans lequel le temps de réaction (ta) de l'actionneur électromagnétique est égal à une durée écoulée entre un instant (t0) de début de circulation du courant électrique dans l'actionneur électromagnétique (1) et un instant (tmin) correspondant à une valeur minimale locale du courant électrique circulant dans l'actionneur électromagnétique (1).

6. Procédé de détection selon l'une des revendications précédentes, dans lequel la grandeur (i1) représentative du courant circulant dans l'actionneur électromagnétique (1) lors de l'actionnement de l'appareil de commutation (30) est une valeur maximale locale du courant électrique circulant dans l'actionneur électromagnétique (1).

7. Procédé de détection selon l'une des revendications précédentes, comprenant les sous-étapes :

- calculer une valeur d'un paramètre statistique (D) représentatif d'une fluctuation des valeurs de l'ensemble (E) de valeurs du polynôme (P) du temps de réaction déterminé (ta) et de la grandeur déterminée (i1),
- déterminer une dégradation de l'actionneur électromagnétique (1) à partir de la valeur calculée du paramètre statistique (D).

8. Procédé de détection selon la revendication précédente, dans lequel le paramètre statistique (D) représentatif d'une fluctuation des valeurs de l'ensemble (E) de valeurs du polynôme du temps de réaction déterminé (ta) et de la grandeur déterminée (i1) comprend une différence (d) entre :

- une valeur courante du polynôme (P) du temps de réaction déterminé (ta) et de la grandeur déterminée (i1), déterminée pour un actionnement courant de l'appareil de commutation (30), et
- une valeur moyenne (Moy) des valeurs du polynôme (P) du temps de réaction déterminé (ta) et de la grandeur déterminée (i1) obtenues pour un nombre prédéterminé (M) d'actionnements précédant l'actionnement courant de l'appareil de commutation (30).

9. Procédé de détection selon la revendication 7 ou 8, dans lequel le paramètre statistique (D) représentatif d'une fluctuation des valeurs de l'ensemble (E) de valeurs du polynôme (P) du temps de réaction déterminé (ta) et de la grandeur déterminée (i1) comprend un écart-type des valeurs du polynôme (P) du temps de réaction déterminé (ta) et de la grandeur déterminée (i1), déterminé pour un ensemble d'actionnements de l'appareil de commutation (30) réalisés dans des conditions de référence correspondant à un état neuf de l'appareil de commutation (30).

10. Procédé de détection selon l'une des revendications 7 à 9, dans lequel le paramètre statistique (D) représentatif d'une fluctuation du polynôme (P) du temps de réaction déterminé (ta) et de la grandeur déterminée (i1) est égal au rapport de :

- la différence (d) entre une valeur courante du polynôme (P) déterminée pour un actionnement courant et la valeur moyenne (Moy) des valeurs du polynôme (P) obtenues pour un nombre prédéterminé (M) d'actionnements précédant l'actionnement courant, et de
- l'écart-type déterminé des valeurs du polynôme (P) du temps de réaction déterminé (ta) et de la grandeur déterminée (i1) déterminé pour un ensemble d'actionnements de l'appareil de commutation (30) réalisés dans des conditions de référence correspondant à un état neuf de l'appareil de commutation (30).

11. Procédé de détection selon l'une des revendications 7 à 10, dans lequel le paramètre statistique (D) représentatif d'une fluctuation du polynôme (P) du temps de réaction déterminé (ta) et de la grandeur déterminée (i1) est égal à :

[Math. 1]

$$D_i = \frac{P_i - \dfrac{\sum_{j=i-M-1}^{j=i-1} P_j}{M}}{\sqrt{\sum_{j=1}^{K}\left(\dfrac{P_j - \dfrac{\sum_{j=1}^{j=K} P_j}{K}}{K}\right)^2}}$$

Avec $P_i$ la valeur déterminée du polynôme (P) pour un actionnement de rang i,
$D_i$ la valeur calculée du paramètre statistique (D) pour l'actionnement de rang i,
M un nombre d'actionnements pris en compte pour déterminer une valeur moyenne,
K un nombre d'actionnements réalisés dans des conditions de référence correspondant à un état neuf de l'appareil de commutation (30).

12. Procédé de détection selon l'une des revendications 7 à 11, dans lequel une dégradation de l'actionneur électromagnétique (1) est déterminée lorsque la valeur absolue du paramètre statistique (D) représentatif d'une fluctuation du polynôme (P) du temps de réaction déterminé (ta) et de la grandeur déterminée (i1) est supérieure à un premier seuil prédéterminé positif (S1).

13. Procédé de détection selon la revendication précédente, dans lequel la dégradation de l'actionneur électromagnétique (1) est classifiée en un premier type de dégradation, dite dégradation mineure, lorsque la valeur absolue du paramètre statistique (D) représentatif d'une fluctuation du polynôme (P) du temps de réaction déterminé (ta) et de la grandeur déterminée (i1) est supérieure à un premier seuil prédéterminé positif (S1) et inférieure à un deuxième seuil prédéterminé positif (S2).

14. Procédé de détection selon la revendication 12 ou 13, dans lequel la dégradation de l'actionneur électromagnétique (1) est classifié en un deuxième type de défaut, dit dégradation majeure, lorsque la valeur absolue du paramètre statistique (D) représentatif d'une fluctuation du polynôme (P) du temps de réaction déterminé (ta) et de la grandeur déterminée (i1) est supérieure au deuxième seuil prédéterminé positif (S2).

15. Procédé de détection selon l'une des revendications précédentes, comprenant une étape d'émission d'un signal d'alerte en réponse à une détermination d'une dégradation de l'actionneur électromagnétique (1).

16. Appareil de commutation (30) comportant :

- un actionneur électromagnétique (1) configuré pour déverrouiller un mécanisme de commande (4) comprenant un organe élastique (7) configuré pour déplacer un contact électrique mobile (10) de façon à ouvrir ou fermer un circuit électrique (50),
- une unité électronique de contrôle (15) configurée pour mettre en œuvre le procédé de détection de dégradation selon l'une des revendications précédentes, dans lequel l'appareil de commutation (30) est un disjoncteur, ou un interrupteur, ou un sectionneur.

**Patentansprüche**

1. Verfahren zum Erkennen einer Verschlechterung einer Schaltvorrichtung (30), umfassend einen elektromagnetischen Aktuator (1), der zum Entriegeln eines Steuermechanismus (4) ausgebildet ist, mit einem elastischen Element (7) das dazu ausgebildet ist, einen beweglichen elektrischen Kontakt (10) zu verschieben, um einen elektrischen Stromkreis (50) zu öffnen oder zu schließen, wobei das Verfahren die folgenden Schritte umfasst:

   (i) Ansteuern des elektromagnetischen Aktuators (1),
   (ii) Messen eines im elektromagnetischen Aktuator (1) fließenden Stroms (C) bei der Ansteuerung des elektromagnetischen Aktuators (1), **gekennzeichnet durch**
   (iii) Bestimmen einer Reaktionszeit (ta) des elektromagnetischen Aktuators (1) aus dem gemessenen Strom (C),
   (iv) Bestimmen einer Größe (i1) aus dem gemessenen Strom (C), die für den bei der Ansteuerung des elektromagnetischen Aktuators (1) fließenden Strom repräsentativ ist,
   (v) Bestimmen eines Parameters (P) in Form eines Polynoms aus der ermittelten Reaktionszeit (ta) und der ermittelten Größe (i1), die für den bei der Ansteuerung des elektromagnetischen Aktuators (1) im elektromagnetischen Aktuator (1) fließenden Strom repräsentativ ist, wobei der Parameter (P) wie folgt geschrieben wird:

$$P = \sum_{i=n}^{H} A_i \times (ta)^{k_i} \times (i1)^{L_i}$$

   wobei:

   die Koeffizienten $k_{01}, \ldots, k_H$ rationale Werte annehmen,
   die Koeffizienten $L_0, \ldots, L_H$ rationale Werte annehmen,
   und die Koeffizienten $A_i$ rationale Werte annehmen,

   (vi) Wiederholen der Schritte (i) bis (v) für eine Gruppe aufeinanderfolgender Ansteuerungen des elektromagnetischen Aktuators (1), um eine Gruppe (E) von Werten des ermittelten Parameters (P) zu erhalten,
   (vii) Bestimmen einer Verschlechterung des elektromagnetischen Aktuators (1) anhand der Entwicklung der Werte der Gruppe (E) während der aufeinanderfolgenden Befehle des elektromagnetischen Aktuators (1).

2. Erkennungsverfahren nach Anspruch 1, wobei die Schaltvorrichtung (30) umfasst:

   - einen elektrischen Kontakt (10), der zwischen einer Öffnungsposition (O) eines Stromkreises (50) und einer Schließposition (F) des Stromkreises (50) beweglich ist,
   - einen Steuermechanismus (4), umfassend:

     o ein elastisches Element (7), das dazu ausgebildet ist, den elektrischen Kontakt (10) aus der Schließstellung (F) in die Öffnungsstellung (O) oder aus der Öffnungsstellung (O) in die Schließstellung (F) zu bewegen, um den Stromkreis (50) zu öffnen bzw. zu schließen,
     ◦ ein Entriegelungselement (8), das dazu ausgebildet ist, aus einer Verriegelungsposition (V), in der das elastische Element (7) in einem gespannten Zustand gehalten wird, in eine Freigabeposition (L) überzugehen, in der sich das elastische Element (7) entspannen kann, um den elektrischen Kontakt (10) aus der Schließstellung (F) in die Öffnungsstellung (O) oder aus der Öffnungsstellung (O) in die Schließstellung (F) zu bewegen,

   - einen elektromagnetischen Aktuator (1), der dazu ausgebildet ist, das Entriegelungselement (8) aus der Verriegelungsstellung (V) in die Freigabestellung (L) zu bewegen.

3. Erkennungsverfahren nach Anspruch 1 oder 2, wobei der Parameter (P) gleich dem Produkt aus der ermittelten Reaktionszeit (ta) und der ermittelten Größe (i1) ist, die für den Strom repräsentativ ist, der bei der Ansteuerung des elektromagnetischen Aktuators (1) in diesem fließt.

4. Erkennungsverfahren nach einem der vorhergehenden Ansprüche, wobei die Reaktionszeit (ta) des elektromagnetischen Aktuators (1) aus den zeitlichen Änderungen des gemessenen Stroms (C) bestimmt wird.

**5.** Erkennungsverfahren nach einem der vorhergehenden Ansprüche, wobei die Reaktionszeit (ta) des elektromagnetischen Aktuators gleich einer Zeitdauer ist, die zwischen einem Zeitpunkt (t0) des Beginns des Fließens des elektrischen Stroms in dem elektromagnetischen Aktuator (1) und einem Zeitpunkt (tmin) vergeht, der einem lokalen Minimalwert des im elektromagnetischen Aktuator (1) fließenden elektrischen Stroms entspricht.

**6.** Erkennungsverfahren nach einem der vorhergehenden Ansprüche, wobei die Größe (i1), die den Strom repräsentiert, der bei Betätigung der Schaltvorrichtung (30) im elektromagnetischen Aktuator (1) fließt, ein lokaler Maximalwert des im elektromagnetischen Aktuator (1) fließenden elektrischen Stroms ist.

**7.** Erkennungsverfahren nach einem der vorhergehenden Ansprüche, mit den folgenden Teilschritten:

- Berechnen eines Wertes eines statistischen Parameters (D), der eine Schwankung der Werte der Gruppe (E) der Werte des Polynoms (P) der ermittelten Reaktionszeit (ta) und der ermittelten Größe (i1) repräsentiert,
- Bestimmen einer Verschlechterung des elektromagnetischen Aktuators (1) anhand des berechneten Werts des statistischen Parameters (D).

**8.** Erkennungsverfahren nach dem vorhergehenden Anspruch, wobei der statistische Parameter (D), der eine Schwankung der Werte der Gruppe (E) der Werte des Polynoms der ermittelten Reaktionszeit (ta) und der ermittelten Größe (i1) repräsentiert, eine Differenz (d) umfasst zwischen:

- einem aktuellen Wert des Polynoms (P) der ermittelten Reaktionszeit (ta) und der ermittelten Größe (i1), der für eine aktuelle Betätigung der Schaltvorrichtung (30) ermittelt wurde, und
- einem Mittelwert (Moy) der Werte des Polynoms (P) der ermittelten Reaktionszeit (ta) und der ermittelten Größe (i1), die für eine vorbestimmte Anzahl (M) von Betätigungen vor der aktuellen Betätigung der Schaltvorrichtung (30) erhalten wurden.

**9.** Erkennungsverfahren nach Anspruch 7 oder 8, wobei der statistische Parameter (D), der eine Schwankung der Werte der Gruppe (E) der Werte des Polynoms (P) der ermittelten Reaktionszeit (ta) und der ermittelten Größe (i1) repräsentiert, eine Standardabweichung der Werte des Polynoms (P) der ermittelten Reaktionszeit (ta) und der ermittelten Größe (i1) umfasst, die für eine Gruppe von Betätigungen der Schaltvorrichtung (30) ermittelt wurde, die unter Referenzbedingungen durchgeführt wurden, die einem Neuzustand der Schaltvorrichtung (30) entsprechen.

**10.** Erkennungsverfahren nach einem der Ansprüche 7 bis 9, wobei der statistische Parameter (D), der eine Schwankung des Polynoms (P) der ermittelten Reaktionszeit (ta) und der ermittelten Größe (i1) darstellt, gleich dem folgenden Verhältnis ist:

- der Differenz (d) zwischen einem aktuellen Wert des Polynoms (P), ermittelt für eine aktuelle Betätigung, und dem Mittelwert (Moy), erhalten für eine vorbestimmte Anzahl (M) von vorhergehenden Betätigungen der Werte des Polynoms (P), und
- der ermittelten Standardabweichung der Werte des Polynoms (P) der ermittelten Reaktionszeit (ta) und der ermittelten Größe (i1), bestimmt für eine Gruppe von Betätigungen der Schaltvorrichtung (30), die unter Referenzbedingungen realisiert wurden, die einem Neuzustand der Schaltvorrichtung (30) entsprechen.

**11.** Erkennungsverfahren nach einem der Ansprüche 7 bis 10, wobei der statistische Parameter (D), der eine Schwankung des Polynoms (P) der ermittelten Reaktionszeit (ta) und der ermittelten Größe (i1) repräsentiert, gleich

[Math. 1] ist:

$$D_i = \frac{P_i - \frac{\sum_{j=i-M-1}^{j=i-1} P_j}{M}}{\sqrt{\sum_{i=1}^{K} \left( \frac{P_i - \frac{\sum_{j=1}^{j=K} P_j}{K}}{K} \right)^2}}$$

wobei Pi der ermittelte Wert des Polynoms (P) ist für eine Betätigung der Ordnung i, $D_i$ der berechnete Wert des statistischen Parameters (D) für die Betätigung der Ordnung i ist, M eine Anzahl von Betätigungen ist, die zur Ermittlung eines Mittelwerts berücksichtigt werden, K eine Anzahl von Betätigungen ist, die unter Referenzbedingungen durchgeführt wurden, die einem Neuzustand der Schaltvorrichtung (30) entsprechen.

12. Erkennungsverfahren nach einem der Ansprüche 7 bis 11, wobei eine Verschlechterung des elektromagnetischen Aktuators (1) festgestellt wird, wenn der Absolutwert des statistischen Parameters (D), der eine Schwankung des Polynoms (P) der ermittelten Reaktionszeit (ta) und der ermittelten Größe (i1) repräsentiert, größer ist als ein erster vorbestimmter positiver Schwellenwert (S1).

13. Erkennungsverfahren nach dem vorhergehenden Anspruch, wobei die Verschlechterung des elektromagnetischen Aktuators (1) in einen ersten Verschlechterungstyp, eine sogenannte geringfügige Verschlechterung, eingestuft wird, wenn der Absolutwert des statistischen Parameters (D), der eine Schwankung des Polynoms (P) der ermittelten Reaktionszeit (ta) und der ermittelten Größe (i1) repräsentiert, größer ist als ein erster vorbestimmter positiver Schwellenwert (S1) und kleiner ist als ein zweiter vorbestimmter positiver Schwellenwert (S2).

14. Erkennungsverfahren nach Anspruch 12 oder 13, wobei die Verschlechterung des elektromagnetischen Aktuators (1) als zweite Art von Fehler, als schwerwiegende Verschlechterung, klassifiziert wird, wenn der absolute Wert des statistischen Parameters (D), der eine Schwankung des Polynoms (P) der ermittelten Reaktionszeit (ta) und der ermittelten Größe (i1) repräsentiert, größer ist als der zweite vorbestimmte positive Schwellenwert (S2).

15. Erkennungsverfahren nach einem der vorhergehenden Ansprüche, umfassend einen Schritt zum Ausgeben eines Warnsignals als Reaktion auf eine Feststellung einer Verschlechterung des elektromagnetischen Aktuators (1).

16. Schaltvorrichtung (30), umfassend:

- einen elektromagnetischen Aktuator (1), der zum Entriegeln eines Steuermechanismus (4) ausgebildet ist, der ein elastisches Element (7) umfasst, das zum Bewegen eines beweglichen elektrischen Kontakts (10) zum Öffnen oder Schließen eines Stromkreises (50) ausgebildet ist,
- eine elektronische Steuereinheit (15), die dazu ausgebildet ist, das Erkennungsverfahren einer Verschlechterung nach einem der vorhergehenden Ansprüche durchzuführen, wobei die Schaltvorrichtung (30) ein Leistungsschalter, ein Trennschalter oder ein Unterbrechungsschalter ist.

**Claims**

1. Method for detecting a degradation of a switching device (30) comprising an electromagnetic actuator (1) configured to unlock a control mechanism (4) comprising an elastic member (7) configured to move a movable electrical contact (10) so as to open or close an electrical circuit (50), the method comprising the steps of:

(i) commanding the electromagnetic actuator (1),
(ii) measuring a current (C) circulating in the electromagnetic actuator (1) during the command of the electromagnetic actuator (1), **characterised by**
(iii) determining from the measured current (C) a reaction time (ta) of the electromagnetic actuator (1),
(iv) determining from the measured current (C) a quantity (i1) representative of the current circulating in the electromagnetic actuator (1) during the command of the electromagnetic actuator (1),
(v) determining a parameter (P) in the form of a polynomial of the determined reaction time (ta) and of the determined quantity (i1) representative of the current circulating in the electromagnetic actuator (1) during the command of the electromagnetic actuator (1), the parameter (P) being written:

$$P = \sum_{i=0}^{H} A_i * (ta)^{K_i} * (i1)^{L_i}$$

with:

the coefficients $k_0, ..., k_H$ taking rational values,
the coefficients $L_0, ..., L_H$ taking rational values,
and the coefficients $A_i$ taking rational values,

(vi) iterating the steps (i) to (v) for a set of successive commands of the electromagnetic actuator (1) so as to obtain a set (E) of values of the determined parameter (P),

(vii) determining a degradation of the electromagnetic actuator (1) from the evolution of the values of the set (E) in the course of the successive commands of the electromagnetic actuator (1).

2. Detection method according to claim 1, wherein the switching device (30) comprises:

- an electrical contact (10) movable between a position for opening (O) an electrical circuit (50) and a position for closing (F) the electrical circuit (50),
- a control mechanism (4) comprising:

-- an elastic member (7) configured to move the electrical contact (10) from the closing position (F) to the opening position (O) or from the opening position (O) to the closing position (F), so as to respectively open or close the electrical circuit (50),
-- an unlocking member (8) configured to pass from a locking position (V) wherein the elastic member (7) is kept in a state of tension to a freeing position (L) wherein the elastic member (7) is free to relax so as to move the electrical contact (10) from the closing position (F) to the opening position (O) or from the opening position (O) to the closing position (F),

- an electromagnetic actuator (1) configured to move the unlocking member (8) from the locking position (V) to the freeing position (L).

3. Detection method according to claim 1 or 2, wherein the parameter (P) is equal to the product of the determined reaction time (ta) and of the determined quantity (i1) representative of the current circulating in the electromagnetic actuator (1) during the command of the electromagnetic actuator (1).

4. Detection method according to one of the preceding claims, wherein the reaction time (ta) of the electromagnetic actuator (1) is determined from the time variations of the measured current (C).

5. Detection method according to one of the preceding claims, wherein the reaction time (ta) of the electromagnetic actuator is equal to a time elapsed between an instant (t0) of start of circulation of the electrical current in the electromagnetic actuator (1) and an instant (tmin) corresponding to a local minimum value of the electrical current circulating in the electromagnetic actuator (1).

6. Detection method according to one of the preceding claims, wherein the quantity (i1) representative of the current circulating in the electromagnetic actuator (1) during the actuation of the switching device (30) is a local maximum value of the electrical current circulating in the electromagnetic actuator (1).

7. Detection method according to one of the preceding claims, comprising the substeps of:

- calculating a value of a statistical parameter (D) representative of a fluctuation of the values of the set (E) of values of the polynomial (P) of the determined reaction time (ta) and of the determined quantity (i1),
- determining a degradation of the electromagnetic actuator (1) from the calculated value of the statistical parameter (D).

8. Detection method according to the preceding claim, wherein the statistical parameter (D) representative of a fluctuation of the values of the set (E) of values of the polynomial of the determined reaction time (ta) and of the determined quantity (i1) comprises a difference (d) between:

- a current value of the polynomial (P) of the determined reaction time (ta) and of the determined quantity (i1), determined for a current actuation of the switching device (30), and
- an average value (Moy) of the values of the polynomial (P) of the determined reaction time (ta) and of the determined quantity (i1) obtained for a predetermined number (M) of actuations preceding the current actuation of the switching device (30).

9. Detection method according to claim 7 or 8, wherein the statistical parameter (D) representative of a fluctuation of the values of the set (E) of values of the polynomial (P) of the determined reaction time (ta) and of the determined quantity (i1) comprises a standard deviation of the values of the polynomial (P) of the determined reaction time (ta) and of the determined quantity (i1), determined for a set of actuations of the switching device (30) carried out under reference conditions corresponding to a new condition of the switching device (30).

10. Detection method according to one of claims 7 to 9, wherein the statistical parameter (D) representative of a fluctuation of the polynomial (P) of the determined reaction time (ta) and of the determined quantity (i1) is equal to the ratio of:

- the difference (d) between a current value of the polynomial (P) determined for a current actuation and the average value (Moy) of the values of the polynomial (P) obtained for a predetermined number (M) of actuations preceding the current actuation, and
- the determined standard deviation of the values of the polynomial (P) of the determined reaction time (ta) and of the determined quantity (i1) determined for a set of actuations of the switching device (30) carried out under reference conditions corresponding to a new condition of the switching device (30).

11. Detection method according to one of claims 7 to 10, wherein the statistical parameter (D) representative of a fluctuation of the polynomial (P) of the determined reaction time (ta) and of the determined quantity (i1) is equal to:

[Math. 1]

$$D_i = \frac{P_i - \frac{\sum_{j=i-M-1}^{j=i-1} P_j}{M}}{\sqrt{\sum_{j=1}^{K} \left( P_j - \frac{\sum_{j=1}^{j=K} P_j}{K} \right)^2}}$$

With $P_i$ the determined value of the polynomial (P) for an actuation of rank i,
$D_i$ the calculated value of the statistical parameter (D) for the actuation of rank i,
M a number of actuations taken into account in order to determine an average value,
K a number of actuations carried out under reference conditions corresponding to a new condition of the switching device (30).

12. Detection method according to one of claims 7 to 11, wherein a degradation of the electromagnetic actuator (1) is determined when the absolute value of the statistical parameter (D) representative of a fluctuation of the polynomial (P) of the determined reaction time (ta) and of the determined quantity (i1) is above a first positive predetermined threshold (S1).

13. Detection method according to the preceding claim, wherein the degradation of the electromagnetic actuator (1) is classified as a first type of degradation, referred to as minor degradation, when the absolute value of the statistical parameter (D) representative of a fluctuation of the polynomial (P) of the determined reaction time (ta) and of the determined quantity (i1) is above a first positive predetermined threshold (S1) and below a second positive predetermined threshold (S2).

14. Detection method according to claim 12 or 13, wherein the degradation of the electromagnetic actuator (1) is classified as a second type of fault, referred to as major degradation, when the absolute value of the statistical parameter (D) representative of a fluctuation of the polynomial (P) of the determined reaction time (ta) and of the determined quantity (i1) is above the second positive predetermined threshold (S2).

15. Detection method according to one of the preceding claims, comprising a step of transmitting an alarm signal in response to a determination of a degradation of the electromagnetic actuator (1).

16. Switching device (30) including:

- an electromagnetic actuator (1) configured to unlock a control mechanism (4) comprising an elastic member (7) configured to move a movable electrical contact (10) so as to open or close an electrical circuit (50),
- an electronic control unit (15) configured to implement the method for detecting degradation according to one of the preceding claims, wherein the switching device (30) is a circuit breaker, or a switch, or a disconnector.

**FIG. 1**

FIG. 2

FIG. 3

**FIG. 4**

FIG. 5

EP 4 492 422 B1

FIG. 6

**EP 4 492 422 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 7692522 B